# EUROPEAN PATENT APPLICATION

(11) **EP 3 836 204 A1**
(43) Date of publication of application: **16.06.2021**
(21) Application number: 19216156.0
(22) Date of filing: 13.12.2019
(51) Int. Cl.: H01L 23/473

(54) **COOLING DEVICE FOR SEMICONDUCTOR SWITCHING ELEMENTS, POWER INVERTER DEVICE AND ARRANGEMENT WITH A POWER INVERTER DEVICE AND AN ELECTRIC MACHINE**

(71) Applicant: Valeo Siemens eAutomotive Germany GmbH, 91056 Erlangen (DE)
(72) Inventor: HUCK, Fabian, 90425 Nürnberg (DE); RAYYA, Monzer, 90431 Nürnberg (DE); TRODLER, Dirk, 91227 Leinburg (DE)
(74) Representative: Dr. Gassner & Partner mbB

(57) **Abstract**

Cooling device (15) for cooling semiconductor switching elements (10, 11), comprising
- a first wall (17) having a first side (18) for carrying the semiconductor switching elements (10, 11) and having a second side (19) being opposite the first side (18),
- a second wall (20) having a first side (21) that forms a main cooling channel (22) together with the second side (19) of the first wall (17) and having a second side (25) being opposite to the first side (21) of the second wall (20), and
- a third wall (23) that forms an auxiliary cooling channel (24) together with the second side (25) of the second wall (20),
wherein the second wall (20) comprises a connection means (26) that connects the auxiliary cooling channel (24) with the main cooling channel (22) in a fluid-conductive manner.

## Description

The present invention relates to a cooling device for cooling semiconductor switching elements, comprising a first wall having a first side for carrying the semiconductor switching elements and having a second side being opposite the first side, and a second wall having a first side that forms a main cooling channel together with the second side of the first wall and having a second side being opposite to the first side of the second wall.

Besides, the present invention relates to a power inverter device and an arrangement with a power inverter device and an electric machine.

When operating semiconductor switching elements, exemplarily within a power inverter device that supplies an electric machine of an electric driven vehicle, significant power losses are generated that may cause overtemperature failures of the semiconductor switching elements. It is known to use a cooling device for cooling the semiconductor switching elements that has a cooling channel in order to allow a coolant to flow subsequently along the semiconductor switching elements for cooling them. Therein, additional heat sink structures, such as pin fins, that extend into the cooling channel may be used, in order to generate turbulences in the coolant and to generate a larger heat exchange surface.

The document US 2004/0150956 A1 discloses a heat sink assembly used in power electronics applications for transferring heat from a heat generating source, that comprises a semiconductor die, to a cooling medium. The heat sink assembly comprises a baseplate, a plurality of thermally conductive pins located inside the baseplate for transferring heat from the heat generating source to the cooling medium and a heat exchange assembly having a top mounting portion and a coolant channel formed therebetween, such that the cooling medium for absorbing heat is located in the cooling channel.

However, due to a sticking heat effect the temperature of the coolant in an outflow region of the single cooling channel is higher than in an inflow region, which decreases a heat transfer from outlet-side semiconductor switching elements and leads to an accumulated increase of heat in an outlet-side part of the cooling device.

Thus, it is an object of the present invention to provide an improved possibility for cooling semiconductor switching elements in a power inverter device, particularly for driving a vehicle.

According to the present invention the above object is solved by an cooling device as described initially, further comprising a third wall that forms an auxiliary cooling channel together with the second side of the second wall, wherein the second wall comprises a connection means that connects the auxiliary cooling channel with the main cooling channel in a fluid-conductive manner.

The cooling device according to the invention provides the auxiliary cooling channel, which is thermally decoupled the semiconductor switching elements via the second wall and, therefore, carries cooler coolant than the main cooling channel. The connection means allows to inject the coolant from the auxiliary cooling channel into the main cooling channel, whereby turbulences are generated within the main cooling channel and/or a temperature of a coolant stream flowing along the main cooling channel is decreased due to mixing the coolant stream with a cooler coolant stream from the auxiliary cooling channel. Both by generating turbulence and by decreasing the temperature of the coolant a higher heat transfer from the semiconductor switching elements to the coolant flowing along the main cooling channel can be achieved. Advantageously, the cooling device according to the invention allows an improved heat dissipation from the semiconductor switching elements and/or allows to omit expensive conventional heat sink structures such as pin fins.

Preferably, the semiconductor switching elements form semiconductor switching element arrangements, each comprising a half-bridge circuit. The half-bridge circuit may comprise a serial connection of two transistor structures each of them provided with an antiparallel diode structure. Typically, three semiconductor switching element arrangements are coolable by the cooling device. Typically, the first wall extends in parallel to the second wall and/or the third wall. Preferably, a distance between the second side of the first wall and the first side of the second wall is larger than a distance between the second side of the second wall and the third wall.

Preferably, the connection means of the cooling device according to the invention is a plurality of through-holes. This allows the coolant stream flowing along the auxiliary cooling channel to be injected into the main cooling channel. Preferably, the through-holes are arranged in rows and lines along the second wall, wherein respective lines extend along a flow direction of the coolant stream in main cooling channel. Preferably, each row comprises at least five, more preferably at least ten, more preferably at least fifteen through-holes. Typically, the through-holes are arranged in a rectangular or elliptical pattern and/or in a diagonal pattern. A ratio of the diameter of a through-hole to the width of the cooling channel is preferably between 1.5 % and 10 %. Furthermore, the diameter of the through-holes may be substantially equal or equal. Alternatively, the diameter of the through-holes may different. Preferably, the diameter of the through-holes is be increasing or decreasing with respect to the flow direction. Thereby, desired requirements of heat transfer and pressure drop can be fulfilled.

It is furthermore preferred that the though-holes are inclined with respect to a plane being parallel to the second wall. Preferably, an inclination angle is at least 10°, more preferably at least 30°, and/or at most 80°, more preferably at most 60°.

The cooling device according to the invention may further comprise an inlet channel assembly for supplying a coolant to the main cooling channel and to the auxiliary cooling channel, and an outlet channel for draining the coolant out of the main cooling channel.

Therein, it is preferred, that a density of connections between the main cooling channel and the auxiliary cooling channel on an outlet-channel-side of the connection means is higher than on an inlet-channel-side of the connection means. As the temperature of the coolant flowing along the main cooling channel typically increases from the inlet-channel-side to the outlet-channel-side, a more balanced temperature distribution of the coolant flowing along the main cooling channel can be achieved by increasing the density of connection, e.g. the density of the through-holes, on the outlet-channel-side.

Besides, it is preferred that the connection means is arranged within a section of the second wall extending between an outlet-channel-side end of the second wall and a position between the outlet channel and the inlet channel assembly, wherein the second wall may be impermeable for the coolant outside the section.

Therein, a distance between the outlet-channel-side end of the second wall and the position is at most 60 percent, preferably at most 50 percent, more preferably at most 40 percent, of the length of the second wall. In this case the coolant from the auxiliary cooling channel can be injected into the main cooling channel only in areas, where the coolant stream along the main cooling channel has already heated up. Thereby, a more balanced heat distribution within the main cooling channel can be achieved.

Alternatively, a distance between the outlet-channel-side end of the second wall and the position is at least 60 percent, preferably at least 75 percent, more preferably at least 90 percent, of the length of the second wall. If the distance is rather high, e.g. more than 60 percent of the length, the coolant from the auxiliary cooling channel can be injected into the main cooling channel over a wide range of the main cooling channel. Thereby, a comparable cooling effect to pin fins or ribbon bonds distributed on the second side of the first wall can be achieved without using such expensive structures.

According to a first preferred alternative, the inlet channel assembly comprises a common inlet channel out of which a main inlet channel and the auxiliary cooling channel branch. This allows a facile integration of the cooling device into a cooling cycle.

According to a second preferred alternative, the inlet channel assembly comprises a main inlet channel and an auxiliary inlet channel being separated from each other. This allows a higher cooling performance, e.g. with respect to an integration of the cooling device into sport vehicles. Particularly, the main inlet channel and the auxiliary inlet channel are suppliable or supplied by separate cooling cycles.

Typically, the cooling device has a single outlet channel for the main cooling channel and the auxiliary cooling channel.

It is preferred that the third wall of the cooling device according to the invention is formed by a bottom of a cavity formed within a housing element. Typically, the cavity is milled into a block of metal or realized by casting the housing element so as to have the cavity. The housing element may be made from aluminum. Typically, the cavity is well-shaped and has at least one bore realizing the inlet channel assembly and/or a bore realizing the outlet channel. The or each bore may be inclined.

Advantageously, the second wall is formed by a plate-like separation element being arranged on a recess of the cavity. This allows a facile construction of the cooling device as the separation element may be a separate component with respect to the housing element. Typically, the separation element is made of plastic in order to realize the weight of the cooling device.

In general, with respect to the cooling device according to the invention, the first wall may be formed by a base plate. The semiconductor switching elements may be mounted on the baseplate by soldering.

According to a first alternative for manufacturing the cooling device comprises a fixing element being arranged between the base plate and the separation element and being elastically deformed by the base plate, when the base plate closes the cavity. According to the second alternative, the cooling device comprises a frame element being arranged between the base plate and the separation element and having a flange that is connected or connectable to a flange of the housing element by a fastener means.

According to the present invention the above object is further solved by a power inverter device, comprising a plurality of semiconductor switching elements and a cooling device for the semiconductor switching elements according to the invention.

According to the present invention the above object is further solved by an arrangement with a power inverter device according to the invention and an electric machine being configured to drive a vehicle, wherein the power inverter device is configured to supply the electric machine.

Further details and advantages of the present invention are described in the following embodiments. Therein, reference is made to the attached drawings which show schematically:
- Fig. 1: a block diagram of an embodiment of an arrangement according to the invention with a first embodiment of a power inverter device according to the invention having a first embodiment of the cooling device according to the invention;
- Fig. 2: a top-view of the first embodiment of the power inverter device;
- Fig. 3: a longitudinal section of the first embodiment of the power inverter device along a plane III-III in Fig. 2;
- Fig. 4: a principle drawing of a second wall of the first embodiment of the cooling device;
- Fig. 5: a simplified cross-section of the first embodiment of the power inverter device showing a main cooling channel and an auxiliary cooling channel;
- Fig. 6: a simplified cross-section of the first embodiment of the power inverter device showing an outlet channel;
- Fig. 7: a cross-section of the first embodiment of the power inverter device along a plane VII-VII in Fig. 2;
- Fig. 8: a top-view on a fixing element of the first embodiment of the cooling device;
- Fig. 9: a longitudinal section of a second embodiment of the power inverter device according to the invention having a second embodiment of the cooling device according to the invention;
- Fig. 10: a longitudinal section of a third embodiment of the power inverter device according to the invention having a third embodiment of the cooling device according to the invention;
- Fig. 11: a principle drawing of the second wall of the third embodiment of the cooling device; and
- Fig. 12: a cross-section corresponding to Fig. 7 of a fourth embodiment of the power inverter device according to the invention having of fourth embodiment of the cooling device according to the invention.

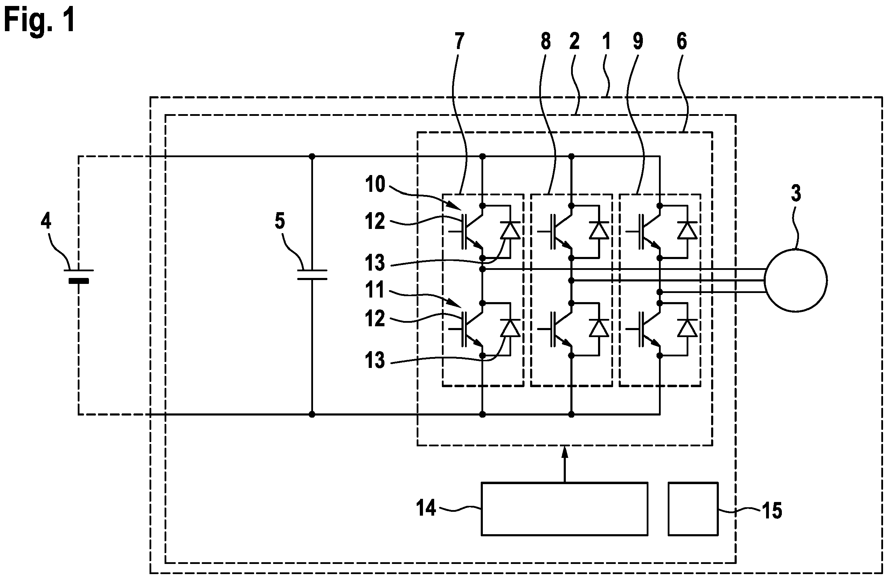

Fig. 1 is a block diagram of an embodiment of an arrangement 1 with a power inverter device 2 and an electric machine 3, wherein the power inverter device 2 is configured to supply the electric machine 3. The electric machine 3 is suitable for driving a vehicle such as a battery electric vehicle or a hybrid electric vehicle. Furthermore, Fig. 1 shows a high-voltage battery 4 connected to a DC link of the power inverter device 2 or to the arrangement 1, respectively.

The power inverter device 2 comprises a DC link capacitor 5, and a semiconductor switching element module 6 having a first semiconductor switching element arrangement 7, a second semiconductor switching element arrangement 8 and a third semiconductor switching element arrangement 9. Each semiconductor switching element arrangement 7, 8, 9 is configured to provide an output phase current of the power inverter device 2. Thereto, each semiconductor switching element arrangement 7, 8, 9 comprises a half-bridge formed by two semiconductor switching elements 10, 11. Each semiconductor switching element has a transistor structure 12 and an antiparallel diode structure 13. The transistor structure 12 and the diode structure 13 may be formed by one or multiple Power-MOSFETs or by one or multiple connections of an IGBT and an diode.

Furthermore, the power inverter device 2 comprises a control unit 14 being configured to control the semiconductor switching element module 6 or the semiconductor switching element arrangements 7, 8, 9, respectively, so as to provide a three-phase output voltage. The power inverter device 2 further comprises a first embodiment of a cooling device 15 for cooling the semiconductor switching elements 10, 11.

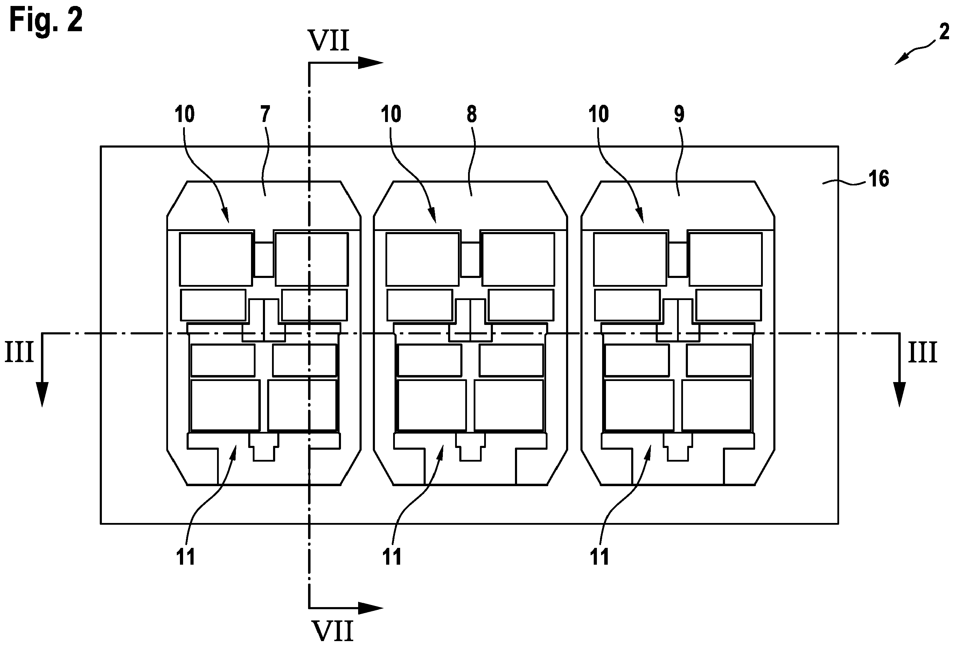

Fig. 2 is a top view of the first embodiment of the power inverter device 2. As can be seen, the semiconductor switching element arrangements 7, 8, 9 are mounted in a row upon a base plate 16 of the cooling device 15.

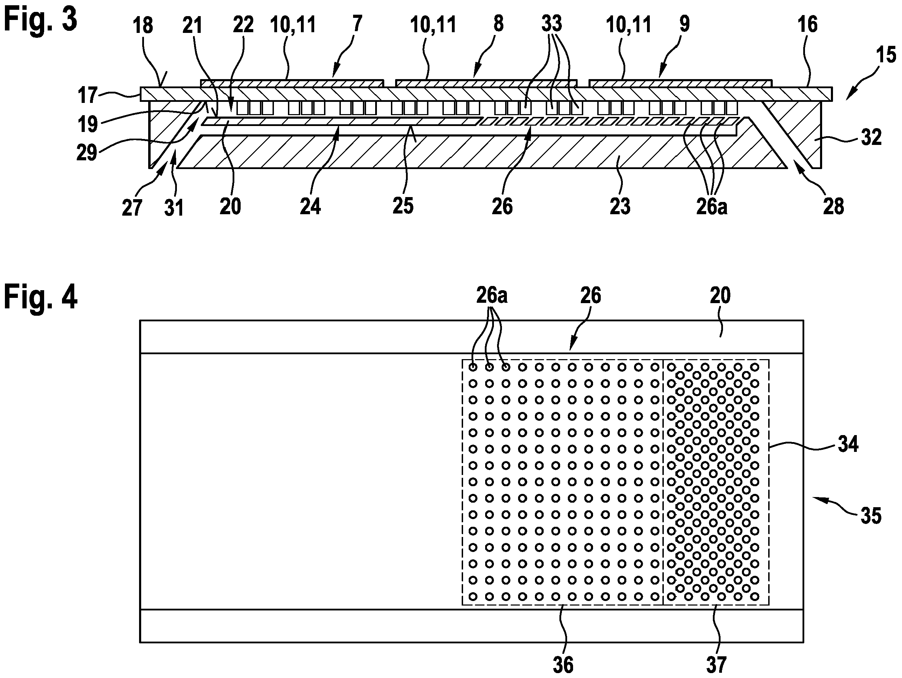

Fig. 3 is a longitudinal section of the first embodiment of the power inverter device 2 along a plane III-III in Fig. 2.

The cooling device 15 comprises a first wall 17, which is formed by the base plate 16. The first wall 17 has a first side 18 for carrying the semiconductor switching elements 10, 11 or the semiconductor switching element arrangements 7, 8, 9, respectively, and a second side 19 being opposite to the first side 18. Furthermore, the cooling device 15 comprises a second wall 20 having a first side 21 that forms a main cooling channel 22 together with the second side 19 of the first wall 17. A third wall 23 of the cooling device 15 forms an auxiliary cooling channel 24 together with a second side 25 of the second wall 20. The main cooling channel 22 and the auxiliary cooling channel 24 extend in parallel below the base plate 16, which is in direct thermal contact with a coolant stream along the main cooling channel 22.

The second wall 20 comprises a connection means 26 that connects the auxiliary cooling channel 24 with the main cooling channel 22 in a fluid conductive manner. Thereto, the connection means 26 comprises a plurality of through-holes 26a that are inclined with respect to a plane being parallel to the second wall 20. Thus, a coolant stream along the auxiliary cooling channel 24, that is thermally decoupled from the semiconductor switching elements 10, 11 by means of the second wall 20, is jetted into the main cooling channel 22 through connections realized by the trough-holes 26a.

Besides, the cooling device 15 comprises an inlet channel assembly 27 for supplying the coolant to the main cooling channel 22 and to the auxiliary inlet channel 24. An outlet channel 28 for draining the coolant out of the main cooling channel 22 is provided on the opposite side with respect to the inlet channel assembly 27 of the cooling device 15. In the present embodiment the inlet channel assembly 27 comprises a common inlet channel 31, from which a main inlet channel 29 for supplying the coolant to the main cooling channel 20 and to the auxiliary cooling channel 24 branch.

The inlet channel assembly 27 and the outlet channel 28 are formed by inclined bores within an housing element 32, exemplarily made of aluminum. Furthermore, Fig. 3 shows optional ribbon bonds 33 arranged on the second side 19 of the first wall 17.

Fig. 4 is a principle drawing of the second wall 20 of the first embodiment of the cooling device 15.

The connection means 26 is arranged within a section 34 of the second wall 20 extending between an outlet-channel-side end 35 of the second wall 20 and a position between the outlet channel 28 and the inlet channel assembly 27. Outside the section 34 the second wall 20 is impermeable for the coolant. The distance between the outlet-channel-side end 35 of the second wall 20 and the position is about 50 percent of the length of the second wall 20.

The section 34 has a first subsection 36 on an inlet-channel-side of the connection means 26 and a second subsection 37 on an outlet-channel-side of the connection means 26. Within the second subsection 37 a density of connections or a density of the through-holes 26a, respectively, is higher than within the first subsection 36. In the first subsection 36 the through-holes 26a are arranged in square pattern, whereas in the second subsection 37 the through-holes 26a are in a diagonal pattern for realizing the higher density of connections.

Thereby, cooler coolant flowing along the auxiliary cooling channel 24 is jetted into a region of the main cooling channel 22, that is below the second and third switching element arrangement 8, 9, where the coolant stream along the main cooling channel 22 has already been heated up due to dissipating heat from the first switching element arrangement 7. As the coolant stream along the auxiliary cooling channel 24 is cooler than the coolant stream along the main cooling channel 22, the temperature below the switching second and third element arrangement 8, 9 decreases in comparison to a cooling device without auxiliary cooling channel. As the density of through-holes 26a in the second subsection 37 being below the third semiconductor switching element arrangement 9 is higher than in the in the first subsection 36, even more coolant is jetted into the main cooling channel 22, therein decreasing the temperature of the coolant stream along the main cooling channel 22 in comparison to a cooling device without auxiliary cooling channel. As turbulences are generated by the coolant jetted through the through-holes 26a, an additional improvement of the heat dissipation is achieved.

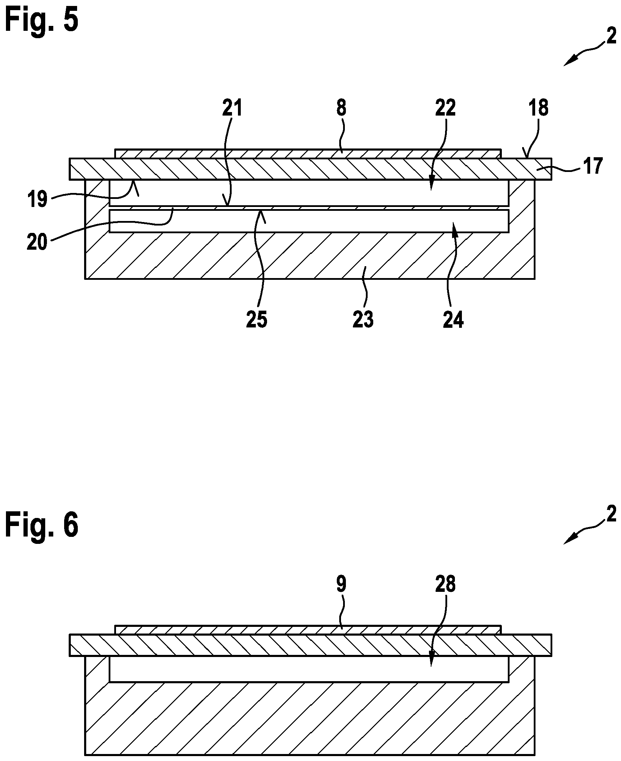

Fig. 5 and Fig. 6 are each a simplified cross-section of the first embodiment of the power inverter device 2, wherein Fig. 5 shows the main cooling channel 22 and the auxiliary cooling channel 24 and Fig. 6 shows the outlet channel 28. As can be seen a distance between the second side 19 of the first wall 17 and the first side 21 of the second wall 20 is larger than a distance between the second side 25 of the second wall 20 and the third wall 23. This results in that the height of the main cooling channel 22 is larger than the height of the auxiliary cooling channel 24.

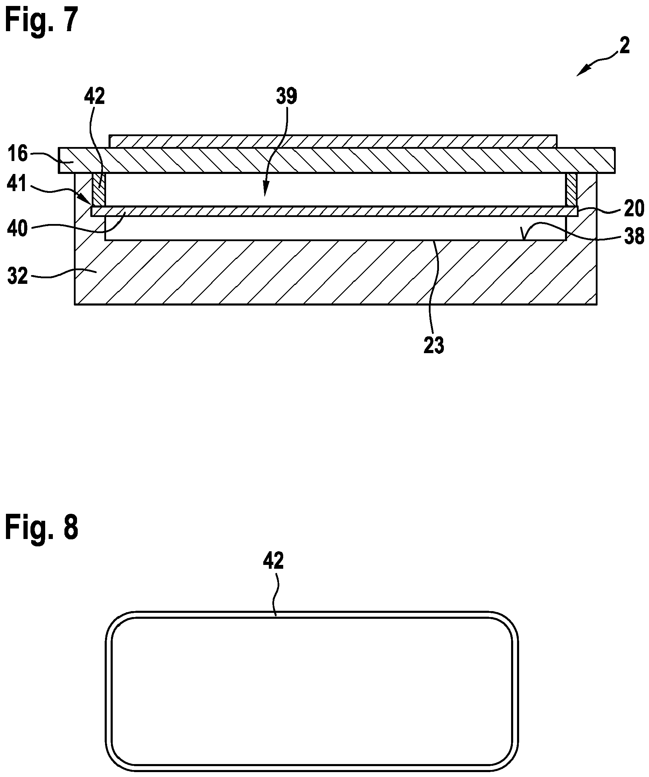

Fig. 7 is a cross-section of the first embodiment of the power inverter device 2 along a plane VII-VII in Fig. 2.

The third wall 23 is formed by the bottom 38 of a cavity 39 formed within the housing element 32. The second wall 20 is formed by a plate-like separation element 40 being arranged on a recess 41 of the cavity 39. A fixing element 42, which is depicted in a top view in Fig. 8, is provided between the base plate 16 and the separation element 42 and is elastically deformed by the base plate 16, when the base plate 16 closes the cavity 39.

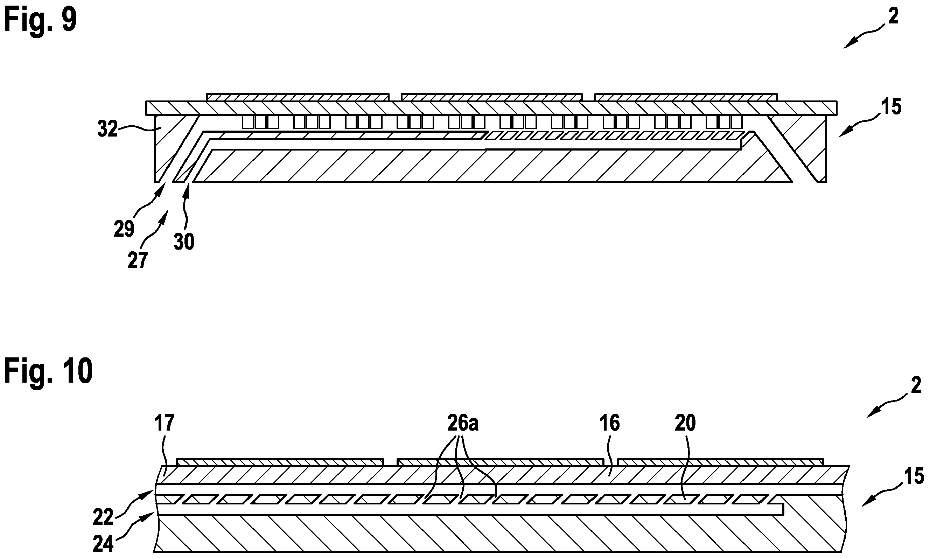

Fig. 9 to Fig. 12 show further embodiments of the power inverter device 2, each having a further embodiment of the cooling device 15. In the following only differences between the respective embodiment and the afore-mentioned first embodiments of the power inverter device 2 and the cooling device 15 are described, wherein identical reference signs are used for identical or equivalent components. All further embodiments of the power inverter device 2 may be applied to the arrangement 1, alternatively.

Fig. 9 is a longitudinal section of the second embodiment of the power inverter device 2 having a second embodiment of the cooling device 15. According to this embodiment the main inlet channel 29 is separated from the auxiliary inlet channel 30. Thereto, two separate bores for each of the inlet channels 29, 30 are provided within the housing element 32. The main inlet channel 29 and the auxiliary inlet channel 30 are supplied by different cooling cycles for providing a higher cooling performance in comparison to the first embodiment.

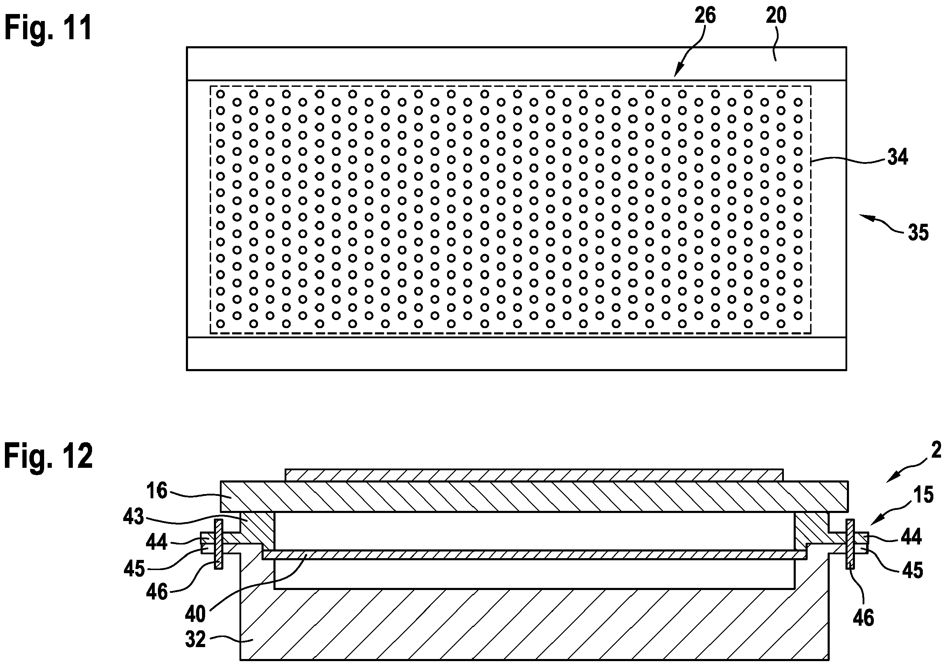

Fig. 10 is a longitudinal section of a third embodiment of the power inverter 2 having a third embodiment of the cooling device 15. In these embodiments the through-holes 26a and distributed nearly over the whole range of the second wall 20. Fig. 11 is a principle drawing of the second wall 20 of the third embodiment of the cooling device 15 as can be seen the section 34 extends to position, whose distance to the outlet-channel-side end 35 is more than 90 percent of the length of the second wall 20. Therein, no ribbon bonds are provided to the base plate 16 as the inclined jets of coolant flowing from the auxiliary cooling channel 24 into the main cooling channel 22 generate turbulences in the main cooling channel 22 comparable to turbulences generated by a corresponding distribution of ribbon bonds on the first wall 17.

Fig. 12 is a cross-section corresponding to Fig. 7 according to a fourth embodiment of the power inverter device 2 having a fourth embodiment of the cooling device 15. In this embodiment the cooling device comprises a frame element 43 being arranged between the base plate 16 and the separation element 40 and having flanges 44 that are connected to flanges 45 of the housing element 32 by fastener means 46.

## Claims

1. Cooling device (15) for cooling semiconductor switching elements (10, 11), comprising
- a first wall (17) having a first side (18) for carrying the semiconductor switching elements (10, 11) and having a second side (19) being opposite the first side (18), and
- a second wall (20) having a first side (21) that forms a main cooling channel (22) together with the second side (19) of the first wall (17) and having a second side (25) being opposite to the first side (21) of the second wall (20),
**characterized by**
a third wall (23) that forms an auxiliary cooling channel (24) together with the second side (25) of the second wall (20), wherein the second wall (20) comprises a connection means (26) that connects the auxiliary cooling channel (24) with the main cooling channel (22) in a fluid-conductive manner.

2. Cooling device according to claim 1, wherein
the connection means (26) is a plurality of through-holes (26a).

3. Cooling device according to claim 2, wherein
the though-holes (26a) are inclined with respect to a plane being parallel to the second wall (20).

4. Cooling device according to any of the preceding claims, further comprising
- an inlet channel assembly (27) for supplying a coolant to the main cooling channel (22) and to the auxiliary cooling channel (24), and
- an outlet channel (28) for draining the coolant out of the main cooling channel (22).

5. Colling device according claim 4, wherein
a density of connections between the main cooling channel (22) and the auxiliary cooling channel (24) on an outlet-channel-side of the connection means (26) is higher than on an inlet-channel-side of the connection means (26).

6. Cooling device according to claim 4 or 5, wherein
the connection means (26) is arranged within a section (34) of the second wall (20) extending between an outlet-channel-side end (35) of the second wall (20) and a position between the outlet channel (28) and the inlet channel assembly (27), wherein the second wall (20) is impermeable for the coolant outside the section (34).

7. Cooling device according to claim 6, wherein
a distance between the outlet-channel-side end (35) of the second wall (20) and the position is
- at most 60 percent, preferably at most 50 percent, more preferably at most 40 percent, or
- at least 60 percent, preferably at least 75 percent, more preferably at least 90 percent,
of the length of the second wall (20).

8. Cooling device according to any of claims 5 to 7, wherein
the inlet channel assembly (27) comprises a common inlet (31) channel out of which a main inlet channel (29) and the auxiliary cooling channel (24) branch.

9. Cooling device according to claims 5 to 7, wherein
the inlet channel assembly (27) comprises a main inlet channel (29) and an auxiliary inlet channel (30) being separated from each other.

10. Cooling device according to any of the preceding claims, wherein
the third wall (23) is formed by a bottom (38) of a cavity (39) formed within a housing element (32).

11. Cooling device according to claim 10, wherein
the second wall (20) is formed by a plate-like separation element (40) being arranged on a recess (41) of the cavity (39).

12. Cooing device according to claim 11, wherein
the first wall (17) is formed by a base plate (16), wherein the cooling device (15) comprises a fixing element (42) being arranged between the base plate (16) and the separation element (40) and being elastically deformed by the base plate (16), when the base plate (16) closes the cavity (39).

13. Cooling device according to claim 11, wherein
the first wall (17) is formed by a base plate (16), wherein the cooling device (15) comprises a frame element (43) being arranged between the base plate (16) and the separation element (40) and having a flange (44) that is connected or connectable to a flange (45) of the housing element (32) by a fastener means (46).

14. Power inverter device (2), comprising a plurality of semiconductor switching elements (10, 11) and a cooling device (15) for the semiconductor switching elements (10, 11) according to any of the preceding claims.

15. Arrangement (1) with a power inverter device (2) according to claim 14 and an electric machine (3) being configured to drive a vehicle, wherein the power inverter device (2) is configured to supply the electric machine (3).
